(19) Europäisches Patentamt
European Patent Office
Office européen des brevets

(11) **EP 3 702 800 A1**

(12) **EUROPEAN PATENT APPLICATION**

(43) Date of publication:
**02.09.2020 Bulletin 2020/36**

(51) Int Cl.:
**G01R 33/565** (2006.01)          **G01R 33/561** (2006.01)
**G01R 33/48** (2006.01)           **G01R 33/54** (2006.01)
**G01R 33/563** (2006.01)

(21) Application number: **19159356.5**

(22) Date of filing: **26.02.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Koninklijke Philips N.V.**
**5656 AG Eindhoven (NL)**

(72) Inventor: **VALVANO, Giuseppe**
**5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **EPI MR IMAGING WITH DISTORTION CORRECTION**

(57)      The invention relates to a method of MR imaging of an object (10) positioned in an examination volume of a MR device (1). An object of the invention is to provide a method that enables EPI imaging with improved distortion correction. The method of the invention comprises the steps of:
- acquiring reference MR signal data from the object (10) using a multi-point Dixon method;
- deriving a Bo map from the reference MR signal data;
- acquiring a series of imaging MR signal data sets from the object (10), wherein an instance of an echo planar imaging sequence is used for acquisition of each imaging MR signal data set, and
- reconstructing an MR image from each imaging MR signal data set, wherein geometric distortions in each MR image are corrected using the Bo map. Moreover, the invention relates to a MR device (1) for carrying out the method, and to a computer program to be run on a MR device (1).

Fig. 1

**Description**

FIELD OF THE INVENTION

The invention relates to the field of magnetic resonance (MR) imaging. It concerns a method of MR imaging of an object positioned in an examination volume of a MR device. The invention also relates to a MR device and to a computer program to be run on a MR device.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MR method in general, the body of the patient to be examined is arranged in a strong, uniform magnetic field $B_0$ whose direction at the same time defines an axis (normally the z-axis) of the co-ordinate system on which the measurement is based. The magnetic field $B_0$ produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view, the distribution of the individual nuclear spins produces an overall magnetization which can be deflected out of the state of equilibrium by application of an electromagnetic pulse of appropriate frequency (RF pulse) while the magnetic field $B_0$ extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant $T_1$ (spin lattice or longitudinal relaxation time), and the magnetization in the direction perpendicular to the z direction relaxes with a second time constant $T_2$ (spin-spin or transverse relaxation time). The variation of the magnetization can be detected by means of receiving RF coils which are arranged and oriented within an examination volume of the MR device in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal (spin echo) in the receiving coils.

In order to realize spatial resolution in the body, linear magnetic field gradients extending along the three main axes are superposed on the uniform magnetic field Bo, leading to a linear spatial dependency of the spin resonance frequency. The signal picked up in the receiving coils then contains components of different frequencies which can be associated with different locations in the body. The signal data obtained via the receiving coils corresponds to the spatial frequency domain and is called k-space data. The k-space data usually includes multiple lines acquired with different phase encoding. Each line is digitized by collecting a number of samples. A set of k-space data is converted to an MR image by means of Fourier transformation.

Echo planar imaging (EPI) is one of the early MR imaging sequences, in which one complete MR imaging data set is formed from a single shot (all k-space lines are acquired after one RF excitation, i.e., in one repetition time) of a gradient echo sequence with an acquisition time of about 20 to 100 ms. By periodically fast reversing the readout or frequency encoding magnetic field gradient, a train of echoes is generated. Phase encoding is achieved by switching of short gradient pulses ("blips") in the phase-encoding direction between the echo acquisitions. The scan time is dependent on the spatial resolution required, the strength of the applied gradient fields and the time the machine needs to ramp the gradients.

EPI with its high temporal resolution is a commonly used technique for dynamic studies such as in functional MRI (fMRI) and contrast agent-enhanced scans. Geometric distortions associated with EPI, however, always degrade the image quality. The EPI distortions originate from off-resonance factors, such as Bo inhomogeneity.

MR imaging is sensitive to diffusion. Known diffusion-weighted imaging (DWI) techniques are commonly performed by using imaging sequences comprising diffusion gradients, wherein the diffusion of protons (of water molecules) along the direction of the diffusion gradient reduces the amplitude of the acquired MR signals. Diffusion tensor imaging (DTI) is a more sophisticated form of DWI, which allows for the determination of both the magnitude and the directionality of diffusion. Diffusion imaging is clinically used, e.g., to detect cancerous tissue. Cancerous lesions show bright signal in diffusion images because of restricted diffusion characterized by a low apparent diffusion coefficient (ADC).

DWI is typically performed using the EPI technique in combination with fat suppression. Therein, spectral fat suppression is performed, e.g., by known SPIR (spectral pre-saturation with inversion recovery) or SPAIR (spectrally attenuated inversion recovery) techniques.

It is known to use conventional Bo field mapping techniques for distortion reduction in EPI. However, such techniques have their limitations. The problem of distortion correction based on a $B_0$ map is ill-posed if phase-encoding gradient blips are applied only in a single direction. It may in this case not be possible to find a solution for distortions leading to signal compressions and/or signal overlaps.

So-called reversed gradient methods are known (see P. S. Morgan et al., Journal of Magnetic Resonance Imaging, vol. 19, 2004, pages 499-507) in which EPI images are acquired with opposed phase-encoding gradient blip directions (in the following referred to as blip-up and blip-down images) to correct distortion in the images. The $B_0$ field map is then calculated as the phase difference between the two EPI imaged divided by the echo time difference. The complex field map needs to be phase-unwrapped and a distortion map is estimated using rigid body registration to the EPI images. Also in this method, the problem of distortion correction is ill-posed (and non-linear).

SUMMARY OF THE INVENTION

From the foregoing it is readily appreciated that there is a need for an improved MR imaging technique. It is consequently an object of the invention to provide a method that enables EPI imaging with improved distortion correction.

In accordance with the invention, a method of MR imaging of an object positioned in an examination volume of a MR device is disclosed. The method comprises the steps of:

- acquiring reference MR signal data from the object using a multi-point Dixon method;
- deriving a $B_0$ map from the reference MR signal data;
- acquiring a series of imaging MR signal data sets from the object, wherein an instance of an echo planar imaging sequence is used for acquisition of each imaging MR signal data set, and
- reconstructing an MR image from each imaging MR signal data set, wherein geometric distortions in each MR image are corrected using the $B_0$ map.

The invention proposes to use $B_0$ information to correct the geometric distortions occurring in EPI imaging. According to the invention, the $B_0$ map is established in a reference scan using a multi-point Dixon method. According to the known multi-point Dixon technique, the spectral difference between fat and water protons is made use of for the purpose of separating MR signals emanating from water containing tissue and MR signals emanating from fat tissue. In multi-point Dixon, multiple acquisitions of k-space are repeated with different echo times. The simplest Dixon technique, 2-point Dixon, acquires two complete k-space data sets, wherein the fat magnetization in the second acquisition is out of phase relative to the first acquisition at the respective echo times. Separate and distinct water and fat images are obtained by simple addition or subtraction of the complex MR signal data sets. In general, a $B_0$ map, a water map and a fat map can be obtained by means of the multi-point Dixon technique. Of particular advantage is that $B_0$ mapping using multi-point Dixon is very fast and provides useful information regarding the water and fat distribution (in the form of water map and a fat map) within the field of view in addition to the $B_0$ map. The $B_0$ map is exploited according to the invention for determining the spatial distribution of $B_0$. The reference MR signal data may be acquired at an image resolution that is lower than the image resolution of the imaging MR signal data. Because of the reduced image resolution, the reference MR signal data can be acquired much faster than the imaging MR signal data.

The $B_0$ map is established once from the reference MR signal data and is then used for distortion correction of each of the series of MR images reconstructed from the imaging MR signal data sets acquired by a corresponding instance of the echo planar imaging sequence.

According to the invention, in other words, a distortion model can be estimated using the $B_0$ map produced by a Dixon pre-scan. The distortion model then enables distortion correction of the acquired EPI images. This approach avoids the need for expensive computations needed to estimate the distortion model from a blip-up/down image pair as it is the case in conventional reversed gradient approach.

In a preferred embodiment, fat suppression is applied. Fat suppression is the process of utilizing specific parameters of the used imaging sequence to remove, to the largest possible extent, the effects of signal contributions from fat protons to the resulting MR image. For example, frequency-selective RF excitation pulses may be applied, which produce saturation of the magnetization of fat protons. Known SPIR or SPAIR techniques may be used for MR signal acquisition in the method of the invention. An advantage of the invention is that the prior knowledge of the water map delivered by the Dixon pre-scan can be included in the reconstruction of the MR images in fat-suppressed EPI imaging in order to further improve image quality.

The invention is especially useful for EPI acquisitions which suffer from large Bo inhomogeneity-induced distortions. A better and more reproducible image quality will be obtained by the method of the invention in particular in combination with EPI used for DWI or dynamic/functional MRI. In dynamic/functional MRI, the reconstructed MR images form a dynamic series, for example for contrast agent-enhanced scans. In DWI/DTI imaging, the imaging MR signal data sets are acquired for different b-values, wherein a diffusion-weighted MR image is derived from the reconstructed series of MR images.

Optionally, in case of distortions leading to signal compressions and/or signal overlaps, one of the imaging MR signal data sets is acquired with a direction of the phase-encoding gradient blips which is opposite to the direction of the phase-encoding gradient blips used in the acquisition of the other imaging MR signal data sets. This additional imaging MR signal data set maybe acquired as an extra time frame in a dynamic scan, or as an extra acquisition at a zero b-value in case of diffusion imaging. There is no need for acquiring the opposed blip direction for every time frame or b-value. Hence, the overall scan time is only insignificantly increased. The additional imaging MR signal data set with opposed blip direction ("blip-down data set") provides prior knowledge on the MR signal distribution in the correspondingly oppositely deformed domain. This can be included in the deformation correction of the MR images in order to further improve image quality.

In a preferred embodiment of the invention, a deformation model is derived from the imaging MR signal data set acquired with opposed phase-encoding gradient blips, which deformation model is then used for correcting the geometric distortions in each MR image. The deformation model can be regarded as a mathematical transformation that, when applied to the undistorted MR image, mimics the occurring distortion. Distortion correction in this case in principal means inversion of the deformation model. For example, the deformation model can be obtained from the additional blip-down data set starting from the Bo map derived from the Dixon pre-scan.

In a preferred embodiment, the correcting of the geometric distortions is performed by solving an inverse problem with a regularization scheme. The regularization scheme can bias each corrected MR image towards a solution which is in congruency with a voxel shift map derived from the Bo map. Moreover, the regularization scheme can bias each corrected MR image towards a solution which is in congruency with the deformation model. Furthermore, the regularization scheme can bias each corrected MR image towards a solution which is in congruency with the water map in order to improve the fat suppression. Finally, the regularization scheme can be used to bias each corrected MR image towards a solution which is spatially smooth. In case of distortions in the form signal compressions a solution that is locally smooth should be preferred.

The method of the invention described thus far can be carried out by means of a MR device including at least one main magnet coil for generating a uniform, steady magnetic field Bo within an examination volume, a number of gradient coils for generating switched magnetic field gradients in different spatial directions within the examination volume, at least one RF coil for generating RF pulses within the examination volume, one or more receiving coils for receiving MR signals from an object positioned in the examination volume, a control unit for controlling the temporal succession of RF pulses and switched magnetic field gradients, and a reconstruction unit. The method of the invention is implemented by a corresponding programming of the reconstruction unit and/or the control unit of the MR device.

The method of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig.1 shows a MR device for carrying out the method of the invention;
Fig.2 schematically shows the method of the invention as a flow chart;
Fig.3 shows examples of brain images illustrating the application of the method of the invention.

DETAILED DESCRIPTION OF THE EMBODIMENTS

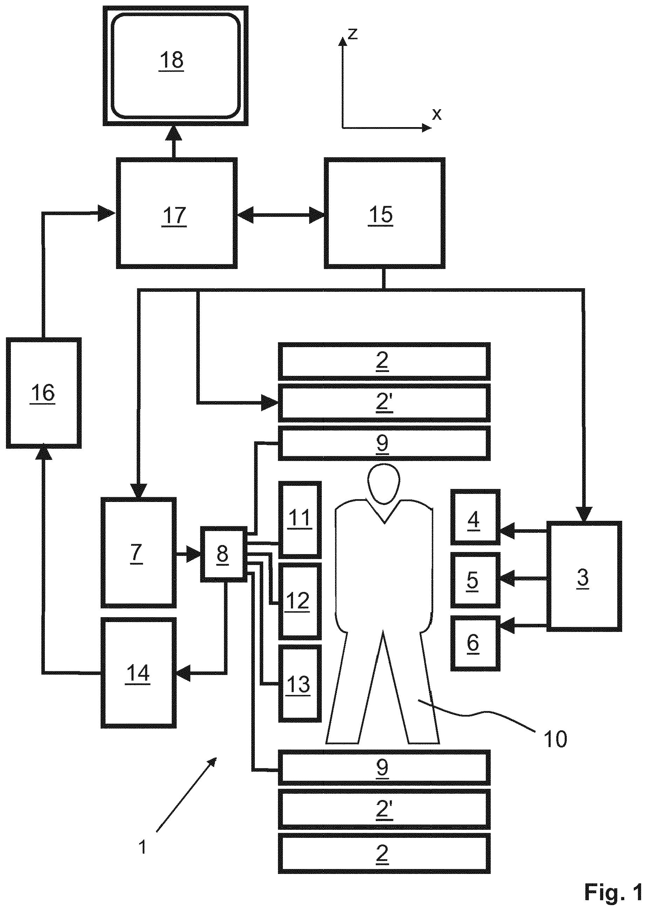

With reference to Fig.1, a MR device 1 is shown. The device comprises superconducting or resistive main magnet coils 2 such that a substantially uniform, temporally constant main magnetic field $B_0$ is created along a z-axis through an examination volume. The device further comprises a set of shimming coils 2', wherein the current flow through the individual shimming coils of the set 2' is controllable for the purpose of minimizing $B_0$ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a body RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 by means of parallel imaging, a set of local array RF coils 11, 12, 13 are placed contiguous to the region selected for imaging. The array coils 11, 12, 13 can be used as receiving coils to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the shimming coils 2' as well as the gradient pulse amplifier 3 and the transmitter 7 to generate any of a plurality of MR imaging sequences, such as echo planar imaging (EPI). For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR devices, the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms, such like SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

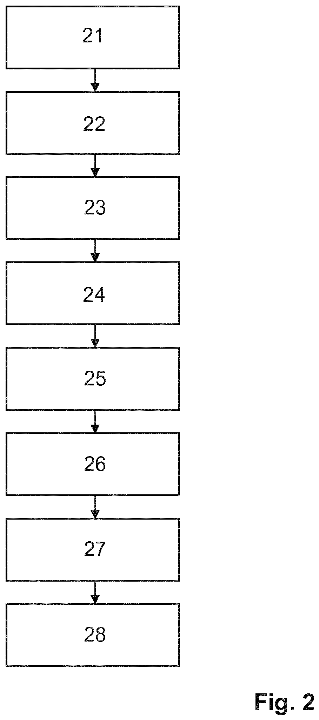

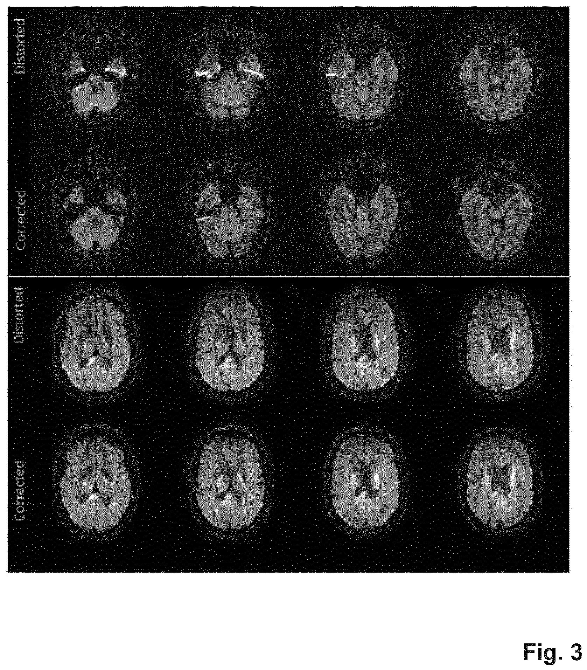

A practical embodiment of the method of the invention is described with reference to Figures 2 and 3 and with further reference to Fig.1 as follows:

After positioning the body 10 in the iso-centre of the main magnet coil 2, a pre-scan is started in step 21 for acquiring reference MR signal data. A multi-point Dixon technique is employed for this purpose. The reference MR signal data are acquired at low resolution, i.e. from a limited central portion of k-space. The whole pre-scan can thus be performed within a couple of seconds.

After the pre-scan, an EPI imaging scan with spectral fat suppression and diffusion weighting is performed at a higher image resolution, i.e. an image resolution that is sufficient for the respective diagnostic imaging task. In step 22, a single imaging MR signal data set is acquired with blip-down phase-encoding for a zero b-value. In step 23, a number of imaging MR signal data sets is acquired with blip-up phase-encoding, again for a zero b-value and further for a number of different b-values.

The reference MR signal data of the Dixon pre-scan are reconstructed in step 4 and a B0 map and a water map are derived. In step 25, a voxel shift map $S_0$ is computed from the B0 map and distortion models corresponding to the blip-up and blip-down acquisitions are derived ($D_{up}$ and $D_{down}$ respectively) starting from the $B_0$ map. A distorted reference image $I_{down}$ is reconstructed in step 25 from the blip-down imaging MR signal data. In step 26, a distorted blip-up MR image $I_{upj}$ is reconstructed for each b-value $j$. A distortion correction is applied in step 27 to produce the undistorted MR images $I_j$. Finally, in step 28, an ADC map is derived indicating the spatially resolved apparent diffusion coefficient of water protons in the imaged tissue region.

The correcting of the geometric distortions is performed in step 27 for each MR image of the series by solving an inverse problem with a regularization scheme as follows:

$$\hat{I} = \arg\min_{I} C\left(D_{up}I - I_{up}\right) + \alpha \left\|\frac{I}{WaterMap}\right\|_2^2 + \beta \left\|\frac{D_{down}I}{I_{down}}\right\|_2^2 + \gamma \left\|W\nabla_y I\right\|_2^2,$$

$$W = \exp(-\nabla_y S_0)$$

Where $C(D_{up}I - I_{up})$ is a data consistency term of any kind, $\nabla_y$ performs the derivative operation along the phase encoding direction, $\alpha, \beta, \gamma$ are regularization parameters. The regularization scheme finds a solution for the distortion-corrected image $\hat{I}$ which is in congruency with the deformation models resulting from both the blip-up and blip-down acquisitions and which is also in conformity with the water map.

In a possible variation of the described scheme, the distortion models $D_{up}$ and $D_{down}$ are derived in the step in step 25 only from the blip-up and blip-down acquisitions, i.e., without combining the information of the $B_0$ map. The prior knowledge on the water signal distribution (water map) could be replaced in step 27 by a prior knowledge on the combination of the water and fat signals in case of a predictably non-successful fat suppression, or it can be omitted. The local smoothness enforcing term $\left\| W \nabla_y I \right\|_2^2$, $W = \exp(-\nabla_y S_0)$, can have a different formulation, or it can be omitted. Any formulation penalizing negative slopes of the shift map $S_0$ would be a valid alternative.

Fig. 3 shows examples of DWI brain images illustrating the application of the method of the invention. Each of the two depicted panels shows in the top row the distorted MR images and in the bottom row the corresponding distortion-corrected MR images. The true anatomy borders are shown as overlays in each image. As can be seen from Fig. 3, the EPI images acquired and corrected according to the invention have substantially reduced geometric distortions.

**Claims**

1. Method of MR imaging of an object (10) positioned in an examination volume of a MR device (1), the method comprising the steps of:

   - acquiring reference MR signal data from the object (10) using a multi-point Dixon method;
   - deriving a $B_0$ map from the reference MR signal data;
   - acquiring a series of imaging MR signal data sets from the object (10), wherein an instance of an echo planar imaging sequence is used for acquisition of each imaging MR signal data set, and
   - reconstructing an MR image from each imaging MR signal data set, wherein geometric distortions in each MR image are corrected using the $B_0$ map.

2. Method of claim 1, wherein the reconstructed MR images form a dynamic series.

3. Method of claim 1, wherein the imaging MR signal data sets are acquired for different b-values, wherein a diffusion-weighted MR image is derived from the reconstructed MR images.

4. Method of any one of claims 1-3, wherein one of the imaging MR signal data sets is acquired with a direction of the phase-encoding gradient blips which is opposite to the direction of the phase-encoding gradient blips used in the acquisition of the other imaging MR signal data sets.

5. Method of claim 4, wherein a deformation model is derived from the imaging MR signal data set acquired with opposite phase-encoding gradient blips, which deformation model is used for correcting the geometric distortions in each MR image.

6. Method of any one of claims 1-5, wherein a water map is derived from the reference MR signal data which is used as prior information in the reconstruction of the MR images.

7. Method of any one of claims 1-6, wherein the correcting of the geometric distortions is performed by solving an inverse problem with a regularization scheme.

8. Method of claim 7, wherein the regularization scheme biases each corrected MR image towards a solution which is in congruency with a voxel shift map derived from the $B_0$ map.

9. Method of claim 7 or 8, wherein the regularization scheme biases each corrected MR image towards a solution which is in congruency with the deformation model.

10. Method of any one of claims 7-9, wherein the regularization scheme biases each corrected MR image towards a solution which is in congruency with the water map.

11. Method of any one of claims 7-10, wherein the regularization scheme biases each corrected MR image towards a solution which is in congruency with a pixel shift map derived from the Bo map.

12. Method of any one of claims 7-11, wherein the regularization scheme further biases each corrected MR image towards a solution which is spatially smooth.

13. MR device including at least one main magnet coil (2) for generating a uniform, steady magnetic field $B_0$ within an examination volume, a number of gradient coils (4, 5, 6) for generating switched magnetic field gradients in different spatial directions within the examination volume, at least one RF coil (9) for generating RF pulses within the examination volume, one or more receiving coils (11, 12, 13) for receiving MR signals from an object (10) positioned in the examination volume, a control unit (15) for controlling the temporal succession of RF pulses and switched magnetic field gradients, and a reconstruction unit (17), wherein the MR device (1) is arranged to perform the following steps:

- acquiring reference MR signal data from the object (10) using a multi-point Dixon method;
- deriving a $B_0$ map from the reference MR signal data;
- acquiring a series of imaging MR signal data sets from the object (10), wherein an instance of an echo planar imaging sequence is used for acquisition of each imaging MR signal data set, and
- reconstructing an MR image from each imaging MR signal data set, wherein geometric distortions in each MR image are corrected using the Bo map.

14. Computer program to be run on a MR device (1), which computer program comprises instructions for:

- acquiring reference MR signal data using a multi-point Dixon method;
- deriving a $B_0$ map from the reference MR signal data;
- acquiring a series of imaging MR signal data sets, wherein an instance of an echo planar imaging sequence is used for acquisition of each imaging MR signal data set, and
- reconstructing an MR image from each imaging MR signal data set, wherein geometric distortions in each MR image are corrected using the $B_0$ map.

**Fig. 1**

```
┌─────────────────────┐
│         21          │
└─────────────────────┘
           │
           ▼
┌─────────────────────┐
│         22          │
└─────────────────────┘
           │
           ▼
┌─────────────────────┐
│         23          │
└─────────────────────┘
           │
           ▼
┌─────────────────────┐
│         24          │
└─────────────────────┘
           │
           ▼
┌─────────────────────┐
│         25          │
└─────────────────────┘
           │
           ▼
┌─────────────────────┐
│         26          │
└─────────────────────┘
           │
           ▼
┌─────────────────────┐
│         27          │
└─────────────────────┘
           │
           ▼
┌─────────────────────┐
│         28          │
└─────────────────────┘
```

**Fig. 2**

Fig. 3

Europäisches
Patentamt
European
Patent Office
Office européen
des brevets

# EUROPEAN SEARCH REPORT

Application Number

EP 19 15 9356

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MORI S. ET AL: "Distortion correction of body diffusion weighted images using three point-Dixon method", PROCEEDINGS OF THE INTERNATIONAL SOCIETY FOR MAGNETIC RESONANCE IN MEDICINE, 18TH SCIENTIFIC MEETING AND EXHIBITION, STOCKHOLM, SWEDEN, 1-7 MAY 2010, vol. 18, 17 April 2010 (2010-04-17), page 4718, XP040616351, * paragraph [0001] - paragraph [0002]; figure 2 * | 1,3,13, 14 | INV. G01R33/565 G01R33/561 G01R33/48 G01R33/54 ADD. G01R33/563 |
| X | CHEN N.-K. ET AL: "Chemical Shift EPI with Real-Time Field-Distortion Correction", PROCEEDINGS OF THE INTERNATIONAL SOCIETY FOR MAGNETIC RESONANCE IN MEDICINE, 4TH ANNUAL MEETING AND EXHIBITION, NEW YORK, NY, USA, 27 APRIL - 03 MAY 1996, vol. 4, 27 April 1996 (1996-04-27), XP040656188, * the whole document * | 1,2,13, 14 | |
| A | WU MINJIE ET AL: "Comparison of EPI Distortion Correction Methods in Diffusion Tensor MRI Using a Novel Framework", 6 September 2008 (2008-09-06), INTERNATIONAL CONFERENCE ON COMPUTER ANALYSIS OF IMAGES AND PATTERNS. CAIP 2017: COMPUTER ANALYSIS OF IMAGES AND PATTERNS; [LECTURE NOTES IN COMPUTER SCIENCE; LECT.NOTES COMPUTER], SPRINGER, BERLIN, HEIDELBERG, PAGE(S) 321 - 329, XP047462374, ISBN: 978-3-642-17318-9 * page 322 - page 324 * | 4 | TECHNICAL FIELDS SEARCHED (IPC) G01R |

-/--

The present search report has been drawn up for all claims

| Place of search | Date of completion of the search | Examiner |
|---|---|---|
| Munich | 9 August 2019 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 19 15 9356

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MARIA KUKLISOVA-MURGASOVA ET AL: "Distortion Correction in Fetal EPI Using Non-Rigid Registration With a Laplacian Constraint", IEEE TRANSACTIONS ON MEDICAL IMAGING., vol. 37, no. 1, 9 February 2017 (2017-02-09), pages 12-19, XP055609938, US ISSN: 0278-0062, DOI: 10.1109/TMI.2017.2667227 * the whole document * | 7-9,11, 12 | |
| A,D | PAUL S. MORGAN ET AL: "Correction of spatial distortion in EPI due to inhomogeneous static magnetic fields using the reversed gradient method", JOURNAL OF MAGNETIC RESONANCE IMAGING, vol. 19, no. 4, 1 January 2004 (2004-01-01), pages 499-507, XP055045448, ISSN: 1053-1807, DOI: 10.1002/jmri.20032 * the whole document * | 1-14 | TECHNICAL FIELDS SEARCHED (IPC) |

The present search report has been drawn up for all claims

| Place of search | Date of completion of the search | Examiner |
|---|---|---|
| Munich | 9 August 2019 | Raguin, Guy |

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P. S. MORGAN et al.** *Journal of Magnetic Resonance Imaging,* 2004, vol. 19, 499-507